# EUROPEAN PATENT APPLICATION

(11) **EP 4 586 634 A1**
(43) Date of publication of application: **16.07.2025**
(21) Application number: 23876962.4
(22) Date of filing: 30.06.2023
(51) Int. Cl.: H04N 25/713, H01L 27/148

(54) **SOLID-STATE IMAGING DEVICE AND SIGNAL PROCESSING METHOD**

(30) Priority: 11.10.2022 JP 2022163147
(71) Applicant: Hamamatsu Photonics K.K., Hamamatsu-shi, Shizuoka 435-8558 (JP)
(72) Inventor: TAKAGI Shin-ichiro, Hamamatsu-shi, Shizuoka 435-8558 (JP)
(74) Representative: Hoffmann Eitle
(86) International application number: PCT/JP2023/024410
(87) International publication number: WO 2024/079953

(57) **Abstract**

A solid-state imaging device includes first and second light receiving units generating charge in response to incidence of light, an output unit that outputs a first signal corresponding to the charge generated in the first light receiving unit and outputs a second signal corresponding to the charge generated in the second light receiving unit, and a signal processing unit processing the signals output from the output unit. Signal processing of the signal processing unit includes an addition signal generation process of adding the first signal and the second signal to generate an addition signal, a subtraction signal generation process of subtracting the second signal from the first signal to generate a subtraction signal, and a correction process of correcting the addition signal on the basis of the subtraction signal then outputting the addition signal.

## Description

### Technical Field

The present disclosure relates to a solid-state imaging device and a signal processing method.

### Background Art

Patent Literature 1 discloses an imaging device. The imaging device includes a horizontal transfer unit that transfers charge generated by photoelectric conversion elements two-dimensionally arranged in a horizontal direction for each line and converts the change into an imaging signal, a transfer control gate unit controlling supply of the charge to the horizontal transfer unit, a driving unit driving the horizontal transfer unit and the transfer control gate unit, and a signal correction unit that generates a correction signal using the imaging signal output from the horizontal transfer unit and then corrects the imaging signal output from the horizontal transfer unit using the correction signal. In addition, the driving unit performs a process of stopping the supply of the charge to the horizontal transfer unit by the transfer control gate unit, and the signal correction unit generates the correction signal using the imaging signal output from the horizontal transfer unit when the supply of the charge to the horizontal transfer unit is stopped.

### Citation List

### Patent Literature

Patent Literature 1: Japanese Unexamined Patent Publication No. 2008-005328

### Summary of Invention

### Technical Problem

However, in the imaging device described above, after shipment, a white spot (hereinafter, referred to as a "WS") with a large amount of signal may occur even in a state in which no light is incident. It is considered that one of the causes of the WS is formation of defects or damage in a crystal structure of a semiconductor (for example, silicon) in a light receiving unit of the imaging device due to alpha rays resulting from a material of the imaging device, such as a packaging, and neutron rays caused by cosmic rays. Since the alpha rays are emitted from the material close to the light receiving unit, it is difficult to provide a shielding material for the light receiving unit. Therefore, it is difficult to block the alpha rays. In addition, the neutron rays coming from the outside world are also difficult to block because neutrons are not charged particles. Therefore, it is difficult to avoid the occurrence of the WS.

Therefore, when the WS occurs after shipment, it is conceivable to continuously use the imaging device while performing correction so as to remove noise caused by the WS in the output signal. However, it is difficult to perform the correction in the imaging device according to the related art for the following reasons: there is a concern that the number of WSs will increase over time; and the output signal may be changed like a random telegraph signal (RTS). Therefore, it is desirable to enable the correction of the output signal and to extend the life of the imaging device.

An object of the present disclosure is to provide a solid-state imaging device and a signal processing method that can achieve a longer life.

### Solution to Problem

[1] According to the present disclosure, there is provided "a solid-state imaging device includes: first and second light receiving units configured to generate charge in response to incidence of light; an output unit configured to output a first signal corresponding to the charge generated in the first light receiving unit and configured to output a second signal corresponding to the charge generated in the second light receiving unit; and a signal processing unit configured to process the signals output from the output unit, in which the first light receiving unit has a first pixel region configured by arranging a plurality of first pixel areas, each of which includes a plurality of first pixels arranged along a first direction or one first pixel, along a second direction intersecting the first direction, the second light receiving unit has a second pixel region configured by arranging a plurality of second pixel areas, each of which includes a plurality of second pixels arranged along the first direction or one second pixel, along the second direction, when the first pixel region and the second pixel region are disposed along the first direction such that end portions of the first pixel region and the second pixel region in the second direction are matched with each other, the first pixel areas and the second pixel areas are associated with each other such that each of the plurality of first pixel areas and each of the plurality of second pixel areas are aligned along the first direction, and signal processing of the signal processing unit includes an addition signal generation process of adding the first signal and the second signal to generate an addition signal, a subtraction signal generation process of subtracting the second signal from the first signal to generate a subtraction signal, and a correction process of correcting the addition signal on the basis of the subtraction signal then outputting the addition signal".

The solid-state imaging device includes the first and second light receiving units generating charge in response to incidence of light. The first light receiving unit has the first pixel region configured by arranging the first pixel areas, each of which includes one or a plurality of first pixels, along the second direction. Similarly, the second light receiving unit has the second pixel region configured by arranging the second pixel areas, each of which includes one or a plurality of second pixels, along the second direction. In the first light receiving unit and the second light receiving unit, charge corresponding to incident light is generated in each of the first pixels and the second pixels.

Then, when the first pixel region and the second pixel region are disposed along the first direction such that the end portions of the first pixel region and the second pixel region in the second direction are matched with each other (it does not matter whether the first pixel region and the second pixel region are actually disposed in this way), the first pixel areas and the second pixel areas are associated with each other such that each of the plurality of first pixel areas and each of the plurality of second pixel areas are aligned along the first direction. Therefore, in the solid-state imaging device, when the same or corresponding light is incident on the first light receiving unit (first pixel region) and the second light receiving unit (second pixel region), a correspondence relationship is established between the first signal corresponding to the charge from the first light receiving unit and the second signal corresponding to the charge from the second light receiving unit.

Therefore, since the signal processing unit generates the subtraction signal between the first signal and the second signal, information related to the output value caused by the WS that may occur regardless of the correspondence relationship between the first signal and the second signal (for example, the position of the pixel area generating the output value caused by the WS or the signal including the output value) can be obtained. Therefore, the addition signal (the output signal before correction) of the first signal and the second signal generated by the signal processing unit can be corrected on the basis of the subtraction signal to remove the output value caused by the WS. As a result, even when the WS occurs over time, it is possible to continuously use the solid-state imaging device while suppressing the influence of the WS. That is, the life of the solid-state imaging device is extended.
[2] According to the present disclosure, "in the solid-state imaging device according to [1], in the correction process, the signal processing unit may generate a correction signal on the basis of the subtraction signal and subtract the correction signal from the addition signal to correct the addition signal, and, when a white spot area, which is the pixel area showing an output value less than a negative threshold value, is recognized in the correction signal, a sign of the output value of the white spot area may be changed to a positive sign". In this case, the correction signal can be subtracted from the addition signal to remove the output value (the output value of the white spot area) caused by the WS from the addition signal.
[3] According to the present disclosure, "in the solid-state imaging device according to [2], in the correction process, the signal processing unit may generate the correction signal in all of the first pixel areas and all of the second pixel areas and subtract the correction signal from the addition signal to correct the addition signal". In this case, it is possible to remove the output value caused by the WS from the addition signal without specifying the position of the white spot area.
[4] According to the present disclosure, "in the solid-state imaging device according to [1], in the correction process, the signal processing unit may generate a correction signal on the basis of the subtraction signal and add the correction signal to the addition signal to correct the addition signal, and when a white spot area, which is the pixel area showing an output value greater than a positive threshold value, is recognized in the correction signal, a sign of the output value of the white spot area may be changed to a negative sign". In this case, the correction signal can be added to the addition signal to remove the output value (the output value of the white spot area) caused by the WS from the addition signal.
[5] According to the present disclosure, "in the solid-state imaging device according to [4], in the correction process, the signal processing unit may generate the correction signal in all of the first pixel areas and all of the second pixel areas and add the correction signal to the addition signal to correct the addition signal". In this case, it is possible to remove the output value caused by the WS from the addition signal without specifying the position of the white spot area.
[6] According to the present disclosure, "in the solid-state imaging device according to any one of [2] to [5], in the correction process, the signal processing unit may set an output value of the pixel area showing the output value between a positive threshold value and a negative threshold value in the correction signal to 0". In this case, the superposition of noise by the subtraction or addition of the correction signal is suppressed.
[7] According to the present disclosure, "in the solid-state imaging device according to [1], in the correction process, when a white spot area, which is the pixel area showing an output value greater than a positive threshold value, is detected in the subtraction signal, the signal processing unit may replace the output value of the white spot area in the addition signal with an output value obtained by doubling an output value of the second pixel area at a position in the second signal corresponding to a position of the white spot area, and, when a white spot area, which is the pixel area showing an output value less than a negative threshold value, is detected in the subtraction signal, the signal processing unit may replace the output value of the white spot area in the addition signal with an output value obtained by doubling an output value of the first pixel area at a position in the first area corresponding to a position of the white spot area". In this case, it is not necessary to subtract and add the correction signal when the output value caused by the WS is removed from the addition signal.
[8] According to the present disclosure, "in the solid-state imaging device according to any one of [1] to [7], when at least one of a white spot area, which is the pixel area showing an output value greater than a positive threshold value, and a white spot area, which is the pixel area showing an output value less than a negative threshold value, is detected in the subtraction signal, the signal processing unit may execute the correction process". In this case, when no white spot area is detected, it is possible to omit the execution of the correction process.
[9] According to the present disclosure, "the solid-state imaging device according to any one of [1] to [8] may further include: a first transfer gate unit configured to transfer the charge from each of the first pixel areas; a second transfer gate unit configured to transfer the charge from each of the second pixel areas; a first horizontal transfer CCD unit configured to transfer the charge transferred by the first transfer gate unit to the output unit; and a second horizontal transfer CCD unit configured to transfer the charge transferred by the second transfer gate unit to the output unit". In this case, it is possible to extend the life of a solid-state imaging device configured to include a CCD (charge coupled device).
[10] According to the present disclosure, "in the solid-state imaging device according to [9], the first pixel region and the second pixel region may be arranged in the first direction such that each of the first pixel areas and each of the second pixel areas are aligned along the first direction". In this case, it is easy to cause the same or corresponding light to be incident on the first pixel region and the second pixel region.
[11] According to the present disclosure, "in the solid-state imaging device according to [10], the first pixel region, the first transfer gate unit, and the first horizontal transfer CCD unit may be sequentially arranged toward one side of the first direction, and the second pixel region, the second transfer gate unit, and the second horizontal transfer CCD unit may be sequentially arranged toward an opposite side of the first direction". In this case, it is possible to appropriately dispose the first horizontal transfer CCD unit, the second horizontal transfer CCD unit, the first transfer gate unit, and the second transfer gate unit for the first pixel region and the second pixel region disposed such that the same or corresponding light is easily incident thereon.
[12] According to the present disclosure, "in the solid-state imaging device according to any one of [1] to [11], the output unit may include: a first output unit configured to receive the charge generated in the first light receiving unit and configured to output the first signal; and a second output unit configured to receive the charge generated in the second light receiving unit and configured to output the second signal". In this case, since the output units corresponding to the first light receiving unit and the second light receiving unit are provided, it is possible to improve a processing speed.
[13] According to the present disclosure, "in the solid-state imaging device according to any one of [1] to [12], the first pixel area may include a plurality of first pixels arranged along the first direction, and the second pixel area may include a plurality of second pixels arranged along the first direction". In this case, binning can be performed, and a signal-to-noise ratio of the output signal is high.
[14] According to the present disclosure, "in the solid-state imaging device according to any one of [1] to [13], the first pixel region and the second pixel region may be disposed adjacent to each other". In this case, since the first pixel region and the second pixel region are disposed adjacent to each other, the characteristics between the regions are close to each other. Therefore, it is possible to perform more appropriate correction.
[15] According to the present disclosure, there is provided "a signal processing method for a solid-state imaging device including first and second light receiving units generating charge in response to incidence of light and an output unit that outputs a first signal corresponding to the charge generated in the first light receiving unit and outputs a second signal corresponding to the charge generated in the second light receiving unit, the signal processing method including: an addition signal generation step of adding the first signal and the second signal to generate an addition signal; a subtraction signal generation step of subtracting the second signal from the first signal to generate a subtraction signal; and a correction step of correcting the addition signal on the basis of the subtraction signal then outputting the addition signal, in which first light receiving unit has a first pixel region configured by arranging a plurality of first pixel areas, each of which includes a plurality of first pixels arranged along a first direction or one first pixel, along a second direction intersecting the first direction, the second light receiving unit has a second pixel region configured by arranging a plurality of second pixel areas, each of which includes a plurality of second pixels arranged along the first direction or one second pixel, along the second direction, and, when the first pixel region and the second pixel region are disposed along the first direction such that end portions of the first pixel region and the second pixel region in the second direction are matched with each other, the first pixel areas and the second pixel areas are associated with each other such that each of the plurality of first pixel areas and each of the plurality of second pixel areas are aligned along the first direction".

According to the signal processing method, it is possible to extend the life of the solid-state imaging device for the same reasons as described above.

### Advantageous Effects of Invention

According to the present disclosure, it is possible to provide a solid-state imaging device and a signal processing method that can achieve a longer life.

### Brief Description of Drawings

[FIG. 1] FIG. 1 is a schematic plan view showing an example of a solid-state imaging device according to this embodiment.
[FIG. 2] FIG. 2 is a schematic partial cross-sectional view taken along a line II-II of FIG. 1 and is a schematic view showing a potential in the cross section.
[FIG. 3] FIG. 3 is a schematic plan view showing another example of the solid-state imaging device according to this embodiment.
[FIG. 4] FIG. 4 is a schematic partial cross-sectional view taken along a line IV-IV of FIG. 3 and is a schematic view showing a potential in the cross section.
[FIG. 5] FIG. 5 is a graph showing various signals.
[FIG. 6] FIG. 6 is a graph showing various signals.
[FIG. 7] FIG. 7 is a flowchart showing an example of a signal processing method according to this embodiment.
[FIG. 8] FIG. 8 is a flowchart showing another example of the signal processing method according to this embodiment.
[FIG. 9] FIG. 9 is a flowchart showing still another example of the signal processing method according to this embodiment.
[FIG. 10] FIG. 10 is a schematic plan view showing a first modification example of the solid-state imaging device.
[FIG. 11] FIG. 11 is a schematic partial cross-sectional view taken along a line XI-XI of FIG. 10 and is a schematic view showing a potential in the cross section.
[FIG. 12] FIG. 12 is a schematic plan view showing another aspect of the solid-state imaging device according to the first modification example.
[FIG. 13] FIG. 13 is a schematic partial cross-sectional view taken along a line XIII-XIII of FIG. 12 and is a schematic view showing a potential in the cross section.
[FIG. 14] FIG. 14 is a schematic plan view showing a second modification example of the solid-state imaging device.
[FIG. 15] FIG. 15 is a schematic enlarged plan view showing a portion of FIG. 14.
[FIG. 16] FIG. 16 is a schematic partial cross-sectional view taken along a line XVI-XVI of FIGS. 14 and 15 and is a schematic view showing a potential in the cross section.

### Description of Embodiments

Hereinafter, an embodiment will be described with reference to the drawings. In the description of each drawing, the same or corresponding portions are denoted by the same reference numerals, and a duplicate description thereof may be omitted. In addition, each drawing may show a rectangular coordinate system consisting of a first axis defining a first direction D1, a second axis defining a second direction D2 intersecting (orthogonal to) the first direction D1, and a third axis defining a third direction D3 intersecting (orthogonal to) the first direction D1 and the second direction D2.

### [Configuration of Solid-State Imaging Device]

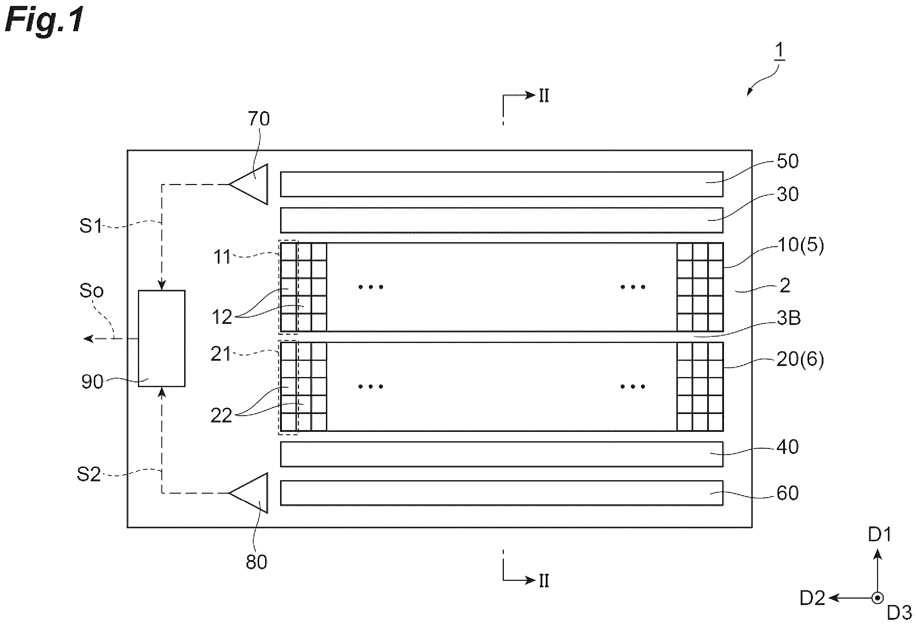

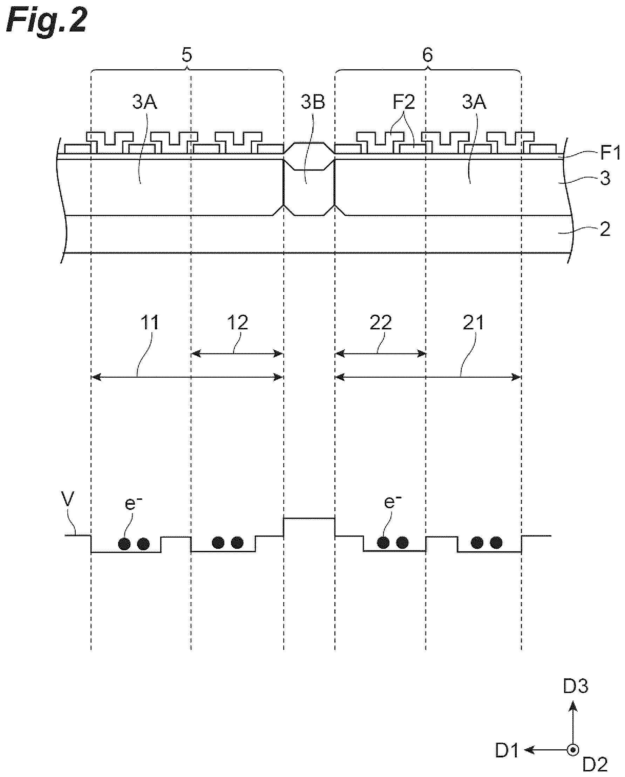

FIG. 1 is a schematic plan view showing an example of a solid-state imaging device according to this embodiment. FIG. 2 is a schematic partial cross-sectional view taken along a line II-II of FIG. 1 and is a schematic view showing a potential in the cross section. A cross-sectional view (without hatching) taken along the line II-II is shown in an upper portion of FIG. 2, and a potential V in the cross section is shown in a lower portion of FIG. 2. The solid-state imaging device 1 shown in FIGS. 1 and 2 is, for example, a CCD image sensor. The solid-state imaging device 1 includes a first pixel region 10 and a second pixel region 20.

The first pixel region 10 has a plurality of first pixel areas 11 arranged along the second direction D2. Each of the first pixel areas 11 includes a plurality of first pixels 12 arranged along the first direction D1. The first pixel 12 generates charge in response to incidence of light. Therefore, the first pixel region 10 constitutes a first light receiving unit 5 generating charge in response to incidence of light. Here, the first light receiving unit 5 is formed in a shape that is longer in the second direction D2 than in the first direction D1 according to the number of first pixels 12 arranged in each of the first direction D1 and the second direction D2. That is, here, the number of first pixels 12 arranged in the second direction D2 is larger than the number of first pixels 12 arranged in the first direction D1.

The second pixel region 20 has a plurality of second pixel areas 21 arranged along the second direction D2. Each of the second pixel areas 21 includes a plurality of second pixels 22 arranged along the first direction D1. The second pixel 22 generates charge in response to incidence of light. Therefore, the second pixel region 20 constitutes a second light receiving unit 6 generating charge in response to incidence of light. Here, the second light receiving unit 6 is formed in a shape that is longer in the second direction D2 than in the first direction D1 according to the number of second pixels 22 arranged in each of the first direction D1 and the second direction D2. That is, here, the number of second pixels 22 arranged in the second direction D2 is larger than the number of second pixels 22 arranged in the first direction D1.

In this embodiment, the number of first pixels 12 arranged in the first pixel region 10 is the same as the number of second pixels 22 arranged in the second pixel region 20 in each of the first direction D1 and the second direction D2. That is, the first pixel region 10 and the second pixel region 20 have the same area. Therefore, here, the number of first pixels 12 included in the first pixel area 11 is the same as the number of second pixels 22 included in the second pixel area 21, and the number of first pixel areas 11 is also the same as the number of second pixel areas 21. That is, in this embodiment, the first pixel region 10 and the second pixel region 20 have the same shape in a plane including the first direction D1 and the second direction D2.

When the first pixel region 10 and the second pixel region 20 are disposed along the first direction D1 such that end portions of the first pixel region 10 and the second pixel region 20 in the second direction D2 are matched with each other, the first pixel areas 11 and the second pixel areas 21 are associated with each other such that each of the plurality of first pixel areas 11 and each of the plurality of second pixel areas 21 are aligned along the first direction D1. In this embodiment, in practice, since the first pixel region 10 and the second pixel region 20 are disposed such that the end portions thereof in the second direction D2 are matched with each other, each of the plurality of first pixel areas 11 and each of the plurality of second pixel areas 21 (which are the same in number as the first pixel areas 11) are arranged in the first direction D1.

The first light receiving unit 5 (first pixel region 10) and the second light receiving unit 6 (second pixel region 20) described above are configured on a semiconductor substrate 2. That is, the solid-state imaging device 1 includes the semiconductor substrate 2, a semiconductor layer 3 stacked on the semiconductor substrate 2, an insulating film F1 formed on a surface of the semiconductor layer 3 opposite to the semiconductor substrate 2, and a plurality of transfer electrodes F2 formed on the insulating film F1. The semiconductor substrate 2 and the semiconductor layer 3 include, for example, silicon. The semiconductor substrate 2 has a first conductivity type (here, a P type).

The semiconductor layer 3 includes a pair of first regions 3A and a second region 3B arranged along the first direction D1 on the semiconductor substrate 2. Each of the first regions 3A has a second conductivity type (here, an N type) different from the first conductivity type. The second region 3B is formed between the pair of first regions 3A and has the first conductivity type (here, a P⁺ type). One first region 3A of the pair of first regions 3A and a region of the semiconductor substrate 2 directly below the one first region 3A constitute the first light receiving unit 5, and the other first region 3A and a region of the semiconductor substrate 2 directly below the other first region 3A constitute the second light receiving unit 6. In addition, the individual first pixels 12 and the individual second pixels 22 are defined according to the disposition of the transfer electrodes F2.

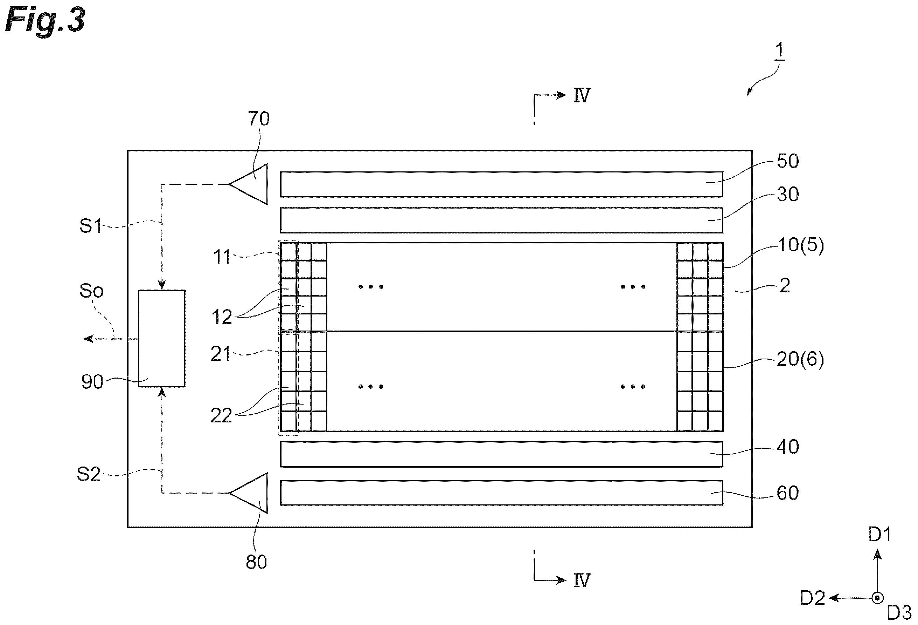

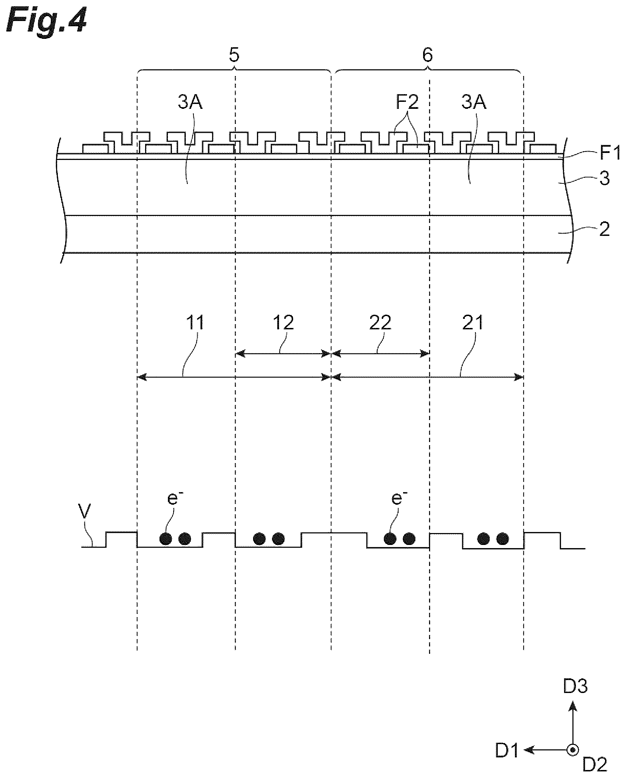

The second region 3B provides a potential barrier against charge e generated in each of the first light receiving unit 5 and the second light receiving unit 6. Therefore, an element isolation portion is formed between the first light receiving unit 5 and the second light receiving unit 6. As a result, the first light receiving unit 5 (first pixel region 10) and the second light receiving unit 6 (second pixel region 20) are disposed adjacent to each other in the first direction D1 with the element isolation portion interposed therebetween. Meanwhile, as shown in FIGS. 3 and 4, the second region 3B of the first conductivity type may not be provided in the semiconductor layer 3 such that the first light receiving unit 5 (first pixel region 10) and the second light receiving unit 6 (second pixel region 20) are disposed adjacent to each other in the first direction D1 without the element isolation portion interposed therebetween.

When the element isolation portion is provided between the first pixel region 10 and the second pixel region 20 (in the case of FIGS. 1 and 2), the occurrence of blooming is suppressed. On the other hand, when the element isolation portion is not provided between the first pixel region 10 and the second pixel region 20 and the first pixel region 10 and the second pixel region 20 are disposed closer to each other (in the case of FIGS. 3 and 4), a dead region is reduced. In addition, FIG. 3 is a schematic plan view showing another example of the solid-state imaging device according to this embodiment. FIG. 4 is a schematic partial cross-sectional view taken along a line IV-IV of FIG. 3 and is a schematic view showing a potential in the cross section. A cross-sectional view (without hatching) taken along the line IV-IV is shown in an upper portion of FIG. 4, and a potential V in the cross section is shown in a lower portion of FIG. 4.

As shown in FIGS. 1 and 3, the solid-state imaging device 1 further includes a first transfer gate unit 30, a second transfer gate unit 40, a first horizontal transfer CCD unit 50, a second horizontal transfer CCD unit 60, a first output unit (output unit) 70, a second output unit (output unit) 80, and a signal processing unit 90.

The first transfer gate unit 30 is disposed on a side of the first pixel region 10 opposite to the second pixel region 20 in the first direction D1 and is provided to transfer the charge from each of the first pixel areas 11 along the first direction D1. The second transfer gate unit 40 is disposed on a side of the second pixel region 20 opposite to the first pixel region 10 in the first direction D1 and is provided to transfer the charge from each of the second pixel areas 21 along the first direction D1.

The first horizontal transfer CCD unit 50 is disposed on the opposite side of the first pixel region 10 in the first direction D1 with the first transfer gate unit 30 interposed therebetween. That is, the first pixel region 10, the first transfer gate unit 30, and the first horizontal transfer CCD unit 50 are sequentially arranged on one side (here, a positive side) of the first direction D1. The first horizontal transfer CCD unit 50 receives the charge transferred by the first transfer gate unit 30 and transfers the charge to the first output unit 70 along the second direction D2. The second horizontal transfer CCD unit 60 is disposed on the opposite side of the second pixel region 20 in the first direction D1 with the second transfer gate unit 40 interposed therebetween. That is, the second pixel region 20, the second transfer gate unit 40, and the second horizontal transfer CCD unit 60 are sequentially arranged on the other side (here, a negative side) of the first direction D1. The second horizontal transfer CCD unit 60 receives the charge transferred by the second transfer gate unit 40 and transfers the charge to the second output unit 80 along the second direction D2.

The first output unit 70 is disposed on one end side of the first horizontal transfer CCD unit 50 in the second direction D2. The first output unit 70 is a first amplifier unit that receives the charge, which has been generated by the first light receiving unit (first pixel region 10) and transferred by the first transfer gate unit 30 and the first horizontal transfer CCD unit 50, converts the charge into a voltage, generates a first signal S1, and outputs the first signal S1. The second output unit 80 is disposed on one end side (the same side as the first output unit 70) of the second horizontal transfer CCD unit 60 in the second direction D2. The second output unit 80 is a second amplifier unit that receives the charge, which has been generated by the second light receiving unit (second pixel region 20) and transferred by the second transfer gate unit 40 and the second horizontal transfer CCD unit 60, converts the charge into a voltage, generates a second signal S2, and outputs the second signal S2.

The signal processing unit 90 receives the input of the first signal S1 from the first output unit 70 and also receives the input of the second signal S2 from the second output unit 80. The signal processing unit 90 performs appropriate processing on the first signal S1 and the second signal S2 to generate an output signal So and outputs the output signal So. In the solid-state imaging device 1, each of the first transfer gate unit 30, the second transfer gate unit 40, the first horizontal transfer CCD unit 50, the second horizontal transfer CCD unit 60, the first output unit 70, the second output unit 80, and the signal processing unit 90 may be configured on the semiconductor substrate 2, or some of these units may be configured outside the semiconductor substrate 2. In addition, in the solid-state imaging device 1, the first light receiving unit 5 and the second light receiving unit 6 may be formed on different semiconductor substrates and arranged as described above.

### [Specific Example of Signal Processing]

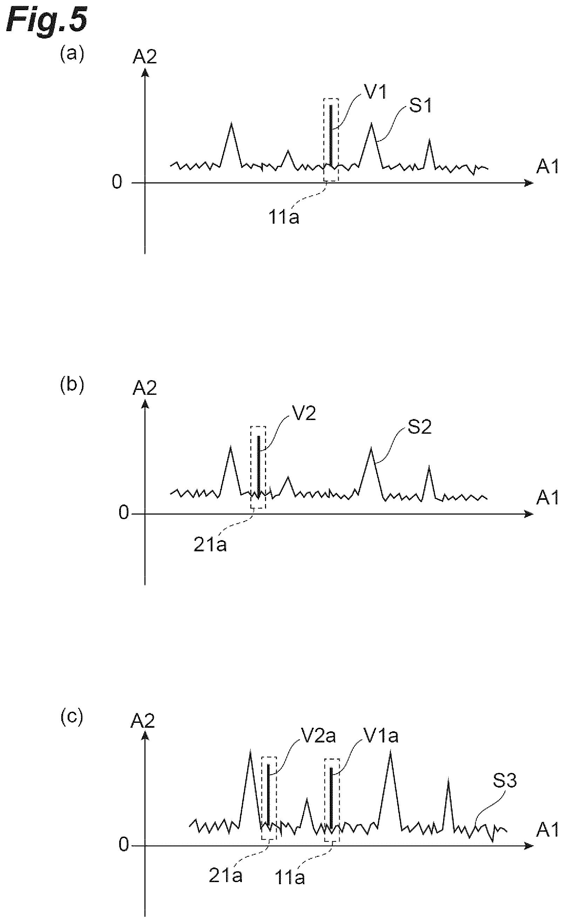

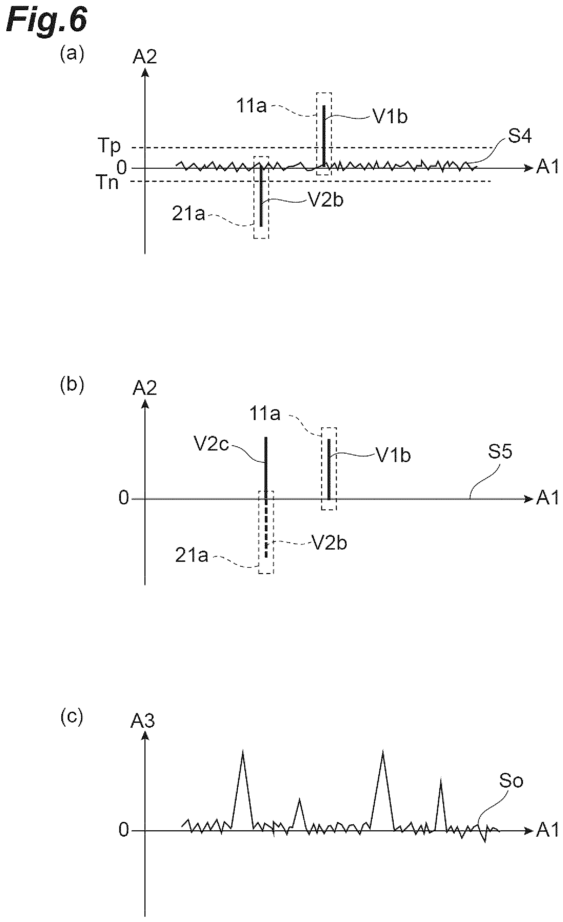

Next, specific signal processing that can be performed by the signal processing unit 90 will be described. FIGS. 5 and 6 are graphs showing various signals. A horizontal axis of each graph indicates the position of the first pixel area 11 or the second pixel area 21 in the second direction D2, and a vertical axis of each graph indicates an output value (voltage value).

Further, hereinafter, it is assumed that light is equally incident on the first pixel region 10 and the second pixel region 20. The equal incidence of light on the first pixel region 10 and the second pixel region 20 can be achieved, for example, by positioning the center of the spread of incident light at a boundary between the first pixel region 10 and the second pixel region 20. The boundary between the first pixel region 10 and the second pixel region 20 is, for example, the center of the element isolation portion in the first direction D1 when the element isolation portion (second region 3B) is interposed between the first pixel region 10 and the second pixel region 20 as shown in FIGS. 1 and 2. In addition, as shown in FIGS. 3 and 4, when the first pixel region 10 and the second pixel region 20 are in direct contact with each other, the boundary is the actual boundary between the first pixel region 10 and the second pixel region 20.

(a) of FIG. 5 shows the first signal S1 input to the signal processing unit 90, and (b) of FIG. 5 shows the second signal S2 input to the signal processing unit 90. Here, in the first signal S1, a WS occurs in one of the plurality of first pixel areas 11, and a relatively high output value V1 is generated. It is assumed that the first pixel area 11 showing the output value V1 is referred to as a WS area (white spot area) 11a. Further, in the second signal S2, a WS occurs in one of the plurality of second pixel areas 21, and a relatively high output value V2 is generated. It is assumed that the second pixel area 21 showing the output value V2 is referred to as a WS area 21a. The position of the WS area 11a in the second direction D2 and the position of the WS area 21a in the second direction D2 are different from each other.

As shown in (c) of FIG. 5, the signal processing of the signal processing unit 90 includes an addition signal generation process of adding the first signal S1 and the second signal S2 to generate an addition signal S3. In the addition signal S3, peaks of the output values of the first signal S1 and the second signal S2 corresponding to incident light images on the first pixel region 10 and the second pixel region 20 are added and increased (for example, twice), and the addition signal S3 includes both an output value V1a corresponding to the output value V1 of the WS area 11a of the first signal S1 and an output value V2a corresponding to the output value V2 of the WS area 21a of the second signal S2. The output value V1a corresponding to the output value V1 is a value obtained by adding the output value of the second pixel area 21 of the second signal S2 corresponding to the WS area 11a of the first signal S1 to the output value V1. In addition, the output value V2a corresponding to the output value V2 is a value obtained by adding the output value of the first pixel area 11 of the first signal S1 corresponding to the WS area 21a of the second signal S2 to the output value V2.

As shown in (a) of FIG. 6, the signal processing of the signal processing unit 90 includes a subtraction signal generation process of subtracting the second signal S2 from the first signal S1 to generate a subtraction signal S4. In the subtraction signal S4, peaks of the output values of the first signal S1 and the second signal S2 corresponding to the incident light images on the first pixel region 10 and the second pixel region 20 are subtracted from each other and removed, but an output value V1b corresponding to the output value V1 of the WS area 11a of the first signal S1 and an output value V2b corresponding to the output value V2 of the WS area 21a of the second signal S2 are not removed and remain because they occur at positions that do not correspond to each other. The output value V1b corresponding to the output value V1 is a value obtained by subtracting the output value of the second pixel area 21 of the second signal S2 corresponding to the WS area 11a of the first signal S1 from the output value V1. Moreover, the output value V2b corresponding to the output value V2 is a value obtained by subtracting the output value V2 from the output value of the first pixel area 11 of the first signal S1 corresponding to the WS area 21a of the second signal S2 and is a negative value.

As shown in (b) of FIG. 6, the signal processing of the signal processing unit 90 includes a correction signal generation process that converts the sign of the output value V2b of the WS area 21a in the subtraction signal S4 into a positive sign to obtain an output value V2c and generates a correction signal S5. In addition, in the signal processing of the signal processor 90, the sign of the output value V1b of the WS area 11a in the subtraction signal S4 may be converted into a negative sign to generate the correction signal S5. The signal processing unit 90 can further perform a noise removal process that sets the output value of the pixel area (the first pixel area 11 and the second pixel area 21) showing the output value between a positive threshold value Tp and a negative threshold value Tn in the correction signal S5 to 0. The noise removal process is performed at any timing. The noise removal process may be performed before a process of inverting the sign of the output value V2b (or the output value V1b) or after or at the same time as the process of inverting the sign of the output value V2b (or the output value V1b).

Therefore, in the correction signal S5, noise other than the noise caused by the WS is removed, and only the output values V1b and V2c (or a negative value of the output value V1b and the output value V2b) caused by the WS remain. The threshold value Tp and the threshold value Tn may be the same or different from each other and may be set to any value capable of removing noise.

As shown in (c) of FIG. 6, the signal processing of the signal processor 90 includes a correction process that subtracts the correction signal S5 generated from the subtraction signal S4 from the addition signal S3 to correct the addition signal S3 and generate the output signal So. Therefore, in the output signal So, only the output values V1a and V2a are removed from the addition signal S3. As described above, in the correction process of the signal processor 90, the addition signal S3 is corrected on the basis of the subtraction signal S4 and then output. In addition, when the signal processing unit 90 converts the sign of the output value V1b of the WS area 11a in the subtraction signal S4 into a negative sign to generate the correction signal S5, the signal processing unit 90 may add the correction signal S5 to the addition signal S3 to correct the addition signal S3 and generate the output signal So. Only the output values V1a and V2a are also moved from the addition signal S3 by this process.

### [Example of Signal Processing Method]

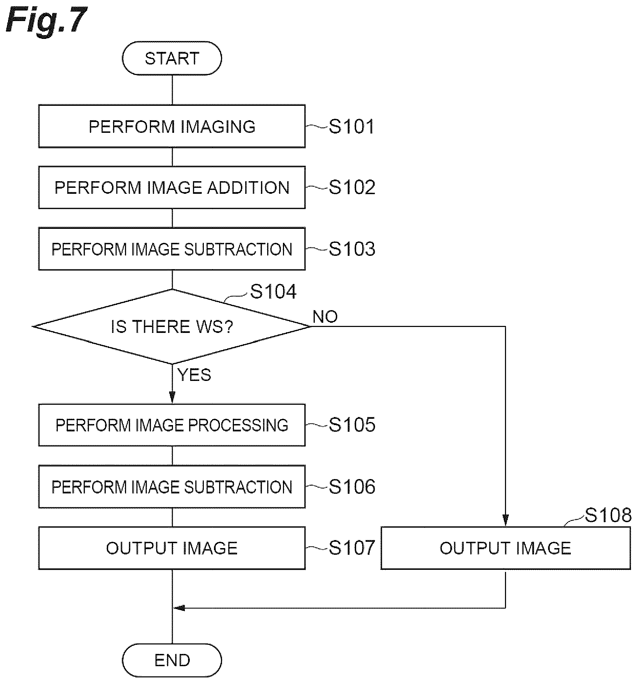

Next, an example of a signal processing method for the solid-state imaging device 1 by the signal processing unit 90 will be described. FIG. 7 is a flowchart showing an example of the signal processing method according to this embodiment. As shown in FIG. 7, in the signal processing method according to this embodiment, first, imaging is performed (Step S101). In Step S101, imaging is performed by causing light to be equally incident on (causing the same light to be incident on) the first pixel region 10 and the second pixel region 20. In Step S101, the first signal S1 and the second signal S2 corresponding to the charge generated in the first pixel region 10 and the second pixel region 20 are generated and input to the signal processing unit 90.

Then, the signal processing unit 90 performs image addition (Step S102: an addition signal generation process and an addition signal generation step). More specifically, in Step S102, the signal processing unit 90 adds the first signal S1 (the image captured in the first pixel region 10) and the second signal S2 (the image captured in the second pixel region 20) to generate the addition signal S3.

Then, in the following Step S103, the signal processing unit 90 performs image subtraction (Step S103: a subtraction signal generation process and a subtraction signal generation step). More specifically, in Step S103, the signal processing unit 90 subtracts the second signal S2 from the first signal S1 to generate the subtraction signal S4. In addition, the order of Step S102 and Step S103 does not matter.

Then, the signal processing unit 90 determines whether a WS is present or absent on the basis of the subtraction signal S4 (Step S104). More specifically, in Step S104, the signal processing unit 90 sets the positive threshold value Tp and the negative threshold value Tn for the subtraction signal S4 and determines whether a pixel area (first pixel area 11) having an output value greater than the positive threshold value Tp is present or absent and whether a pixel area (second pixel area 21) having an output value less than the negative threshold value Tn is present or absent in the subtraction signal S4.

When it is determined in Step S104 that the WS is not detected in the subtraction signal S4 (Step S104: No), the signal processing unit 90 outputs the addition signal S3 (image) as the output signal So (Step S108) and ends the process. That is, when there is no WS in the subtraction signal S4, the signal processing unit 90 does not perform the correction process.

On the other hand, when it is determined in Step S104 that the WS is detected in the subtraction signal S4 (Step S104: Yes), that is, when at least one of the WS area 11a, which is a pixel area showing the output value V1 greater than the positive threshold value Tp, and the WS area 21a, which is a pixel area showing the output value V2 less than the negative threshold value Tn, is detected in the subtraction signal S4, the signal processing unit 90 performs image processing (step S105: a correction process and a correction step).

More specifically, in Step S105, when the WS area 21a, which is a pixel area showing the output value V2b less than the negative threshold value Tn, is recognized in the subtraction signal S4, the signal processing unit 90 changes the sign of the output value V2b of the WS area 21a in the subtraction signal S4 to a positive sign to generate the correction signal S5. At this time, the signal processing unit 90 can set the output value of the pixel area showing the output value between the positive threshold value Tp and the negative threshold value Tn in the correction signal S5 to 0.

Then, the signal processing unit 90 subtracts the correction signal S5 from the addition signal S3 to correct the addition signal S3 and generates the output signal S0 (Step S106: a correction process and a correction step). Therefore, the output values V1a and V2a caused by the WS are removed from the addition signal S3. As described above, in Steps S105 and S106, the signal processing unit 90 corrects the addition signal S3 on the basis of the subtraction signal S4. Further, in Step S106, the signal processing unit 90 can generate the correction signals S5 in all of the first pixel areas 11 and all of the second pixel areas 21 and subtract the correction signal S5 from the addition signal S3 to correct the addition signal S3.

Then, the signal processing unit 90 outputs the correction signal S5 as the output signal So (image) (Step S107) and ends the process.

In addition, in Step S105, when the WS area 11a, which is a pixel area showing the output value V1b greater than the positive threshold value Tp, is recognized in the subtraction signal S4, the signal processing unit 90 may change the sign of the output value V1b of the WS area 11a in the subtraction signal S4 to a negative sign to generate the correction signal S5. In this case, the signal processing unit 90 can also set the output value of the pixel area showing the output value between the positive threshold value Tp and the negative threshold value Tn in the correction signal S5 to 0.

Then, in this case, in Step S106, the signal processing unit 90 can add the correction signal S5 to the addition signal S3 to correct the addition signal S3 and generate the output signal S0. Therefore, the output values V1a and V2a caused by the WS are removed from the addition signal S3. Even in this case, in Step S106, the signal processing unit 90 may generate the correction signal S5 in all of the first pixel areas 11 and all of the second pixel areas 21 and add the correction signal S5 to the addition signal S3 to correct the addition signal S3.

### [Another Example of Signal Processing Method]

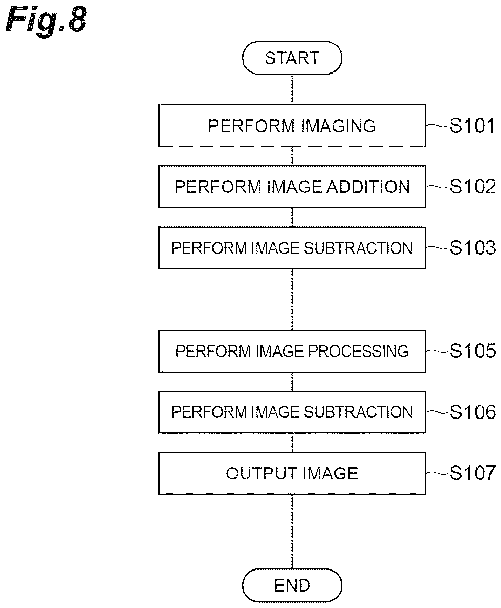

Next, another example of the signal processing method for the solid-state imaging device 1 by the signal processing unit 90 will be described. FIG. 8 is a flowchart showing another example of the signal processing method according to this embodiment. As shown in FIG. 8, the signal processing method according to this example differs from the signal processing method according to the example shown in FIG. 7 only in that Step S106 of determining whether a WS is present or absent is not performed.

That is, here, after generating the addition signal S3 and the subtraction signal S4 in Steps S102 and S103, the signal processing unit 90 performs the image processing in Step S105 and the subtraction (or addition) of the image in Step S106, regardless of whether the WS is present or absent in the subtraction signal S4. Therefore, the process of determining whether the WS is present or absent is not needed.

### [Still Another Example of Signal Processing Method]

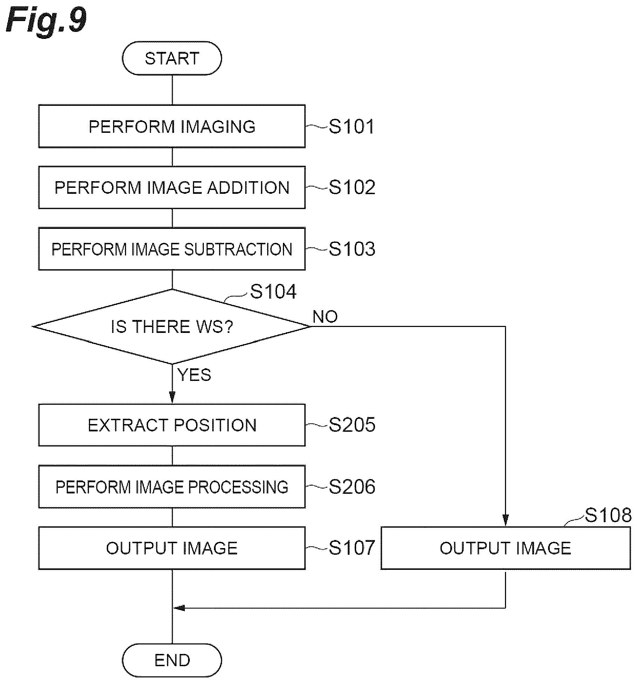

Next, still another example of the signal processing method for the solid-state imaging device 1 by the signal processing unit 90 will be described. FIG. 9 is a flowchart showing still another example of the signal processing method according to this embodiment. As shown in FIG. 9, in the signal processing method according to this example, similarly to the signal processing method according to the example shown in FIG. 7, Steps S101, S102, and S103 are performed to generate the addition signal S3 and the subtraction signal S4, and Step S104 is performed to determine whether or not a WS is present or absent in the subtraction signal S4. In addition, the subtraction signal S4 is generated by subtracting the second signal S2 from the first signal S1. Therefore, when the WS area 11a, which is a pixel area showing the output value V1b greater than the positive threshold value Tp, is detected in the subtraction signal S4, the first signal S1 includes the output value V1 corresponding to the WS. When the WS area 21a, which is a pixel area showing the output value V2b less than the negative threshold value Tn, is detected in the subtraction signal S4, the second signal S2 includes the output value V2 corresponding to the WS.

Then, when it is determined in Step S104 that the WS is detected in the subtraction signal S4 (Step S104: Yes), that is, when at least one of the WS area 11a, which is a pixel area showing the output value V1b greater than the positive threshold value Tp, and the WS area 21a, which is a pixel area showing the output value V2b less than the negative threshold value Tn, is detected in the subtraction signal S4, the signal processing unit 90 extracts the position of the detected WS area 11a and/or WS area 21a in the second direction D2 (Step S205).

Then, the signal processing unit 90 performs image processing on the addition signal S3 on the basis of information related to the position of the WS extracted in Step S205 (Step S206: a correction process and a correction step). More specifically, in Step S206, when the WS area 11a is detected, the signal processing unit 90 replaces the output value V1a of the WS area 11a in the addition signal S3 with an output value obtained by doubling the output value of the second pixel area 21 at the position of the WS area 11a in the second signal S2.

Alternatively, in Step S206, when the WS area 21a is detected, the signal processing unit 90 replaces the output value V2a of the WS area 21a in the addition signal S3 with an output value obtained by doubling the output value of the first pixel area 11 at the position of the WS area 21a in the first signal S1. Therefore, the output value V1a caused by the WS included in the addition signal S3 can be corrected to a normal value corresponding to the output value of the second signal S2, and the output value V2a caused by the WS included in the addition signal S3 can be corrected to a normal value corresponding to the output value of the first signal S1.

As described above, in Step S206, when the WS area 11a, which is a pixel area showing the output value V1b greater than the positive threshold value Tp, is detected in the subtraction signal S4, the signal processing unit 90 replaces the output value V1a of the WS area 11a in the addition signal S3 with an output value obtained by doubling the output value of the second pixel area 21 at the position of the WS area 11a in the second signal S2. When the WS area 21a, which is a pixel area showing the output value less than the negative threshold value Tn, is detected in the subtraction signal S4, the signal processing unit 90 replaces the output value V2a of the WS area 21a in the addition signal S3 with an output value obtained by doubling the output value of the first pixel area 11 at the position of the WS area 21a in the first signal S1. Therefore, the output values V1a and V2a caused by the WS are removed from the addition signal S3. The subsequent processes are the same as those in the example shown in FIG. 7.

In addition, in Step S206, when the output value V1a and the output value V2a of the addition signal S3 are replaced with the output value of the first signal S1 or the output value of the second signal S2, it may be determined whether or not the output value sed for the replacement is appropriate. As an example of this case, the signal processing unit 90 may determine whether or not the output value used for the replacement is a value between 0 and a predetermined positive threshold value Tpa, using the threshold value Tpa that is set to be equal to or greater than the maximum value of the output value of the pixel area in which the WS does not occur and to be equal to or less than an output value obtained by superimposing the WS on the output value (noise) when no light is incident. Then, when it is determined that the output value used for the replacement is a value between 0 and the threshold value Tpat, the replacement can be executed.

That is, in Step S206, when the WS area 11a, which is a pixel area showing the output value V1b greater than the positive threshold value Tp, is detected in the subtraction signal S4 and the output value of the second pixel area 21 at the position of the WS area 11a in the second signal S2 is a value between 0 and the threshold value Tpa, the signal processing unit 90 can replace the output value V1a of the WS area 11a in the addition signal S3 with an output value obtained by doubling the output value of the second pixel area 21 at the position of the WS area 11a in the second signal S2.

Further, in Step S206, when the WS area 21a, which is a pixel area showing the output value less than the negative threshold value Tn, is detected in the subtraction signal S4 and the output value of the first pixel area 11 at the position of the WS area 21a in the first signal S1 is a value between 0 and the threshold value Tpa, the signal processing unit 90 can replace the output value V2a of the WS area 21a in the addition signal S3 with an output value obtained by doubling the output value of the first pixel area 11 at the position of the WS area 21a in the first signal S1. In addition, the positive threshold value Tpa used here may be a value different from the positive threshold value Tp used to determine whether the WS is present or absent in the subtraction signal S4 in Step S104.

### [Operation and Effect]

As described above, the solid-state imaging device 1 according to this embodiment includes the first light receiving unit 5 and the second light receiving unit 6 generating charge in response to the incidence of light. The first light receiving unit 5 has the first pixel region 10 configured by arranging the first pixel areas 11, each of which includes a plurality of first pixels 12, along the second direction D2, and the second light receiving unit 6 similarly has the second pixel region 20 configured by arranging the second pixel areas 21, each of which includes a plurality of second pixels 22, along the second direction D2. In the first light receiving unit 5 and the second light receiving unit 6, charge corresponding to incident light is generated in each of the first pixel 12 and the second pixel 22.

Then, when the first pixel region 10 and the second pixel region 20 are disposed along the first direction D1 (they are actually disposed in this way in this embodiment) such that the end portions of the first pixel region 10 and the second pixel region 20 in in the second direction D2 are matched with each other, the first pixel areas 11 and the second pixel areas 21 are associated with each other such that each of the plurality of first pixel areas 11 and each of the plurality of second pixel areas 21 are aligned along the first direction D1. Therefore, in the solid-state imaging device 1, when the same or corresponding light is incident on the first light receiving unit 5 (first pixel region 10) and the second light receiving unit 6 (second pixel region 20), a correspondence relationship is established between the first signal S1 corresponding to the charge from the first light receiving unit 5 and the second signal S2 corresponding to the charge from the second light receiving unit 6.

Therefore, when the signal processing unit 90 generates the subtraction signal S4 between the first signal S1 and the second signal S2, information related to the output values V1 and V2 caused by the WS which may occur regardless of the correspondence relationship between the first signal S1 and the second signal S2 (for example, information related to the position of the pixel area generating the output values V1 and V2 caused by the WS or the signal including the output values V1 and V2) can be obtained. Therefore, the addition signal S3 (the output signal So before correction) of the first signal S1 and the second signal S2 generated by the signal processing unit 90 can be corrected on the basis of the subtraction signal S4 to remove the output values V1a and V2a caused by the WS. As a result, even when the WS occurs over time, it is possible to continuously use the solid-state imaging device 1 while suppressing the influence of the WS. That is, it is possible to extend the life of the solid-state imaging device 1.

Further, in the solid-state imaging device 1 according to this embodiment, in the correction process, the signal processing unit 90 can generate the correction signal S5 on the basis of the subtraction signal S4 and subtract the correction signal S5 from the addition signal S3 to correct the addition signal S3. At this time, in the correction signal S5, when the WS area 21a, which is a pixel area showing the output value V2b less than the negative threshold value Tn, is recognized, the sign of the output value V2b of the WS area 21a is changed to a positive sign. Therefore, the correction signal S5 can be subtracted from the addition signal S3 to remove the output values V1a and V2a caused by the WS from the addition signal S3, and the output signal So can be generated.

Furthermore, in the solid-state imaging device 1 according to this embodiment, in the correction process, the signal processing unit 90 can set the output value of the pixel area showing the output value between the positive threshold value Tp and the negative threshold value Tn in the correction signal S5 to 0. Therefore, the superimposition of noise by the subtraction of the correction signal S5 is suppressed.

Moreover, in the solid-state imaging device 1 according to this embodiment, in the correction process, the signal processing unit 90 can generate the correction signal S5 in all of the first pixel areas 11 and all of the second pixel areas 21 and subtract the correction signal S5 from the addition signal S3 to correct the addition signal S3. Therefore, it is possible to remove the output values V1a and V2a caused by the WS from the addition signal S3 without specifying the position of the WS area.

In addition, in the solid-state imaging device 1 according to this embodiment, in the correction process, the signal processing unit 90 may generate the correction signal S5 on the basis of the subtraction signal S4 and add the correction signal S5 to the addition signal S3 to correct the addition signal S3. At this time, in the correction signal S5, when the WS area 11a, which is a pixel area showing the output value V1b greater than the positive threshold value Tp, is recognized, the sign of the output value V1b of the WS area 11a may be changed to a negative sign. In this case, the correction signal S5 can be added to the addition signal S3 to remove the output values V1a and V2a caused by the WS from the addition signal S3.

Further, in this case, in the correction process, the signal processing unit 90 may generate the correction signal S5 in all of the first pixel areas 11 and all of the second pixel areas 21 and add the correction signal S5 to the addition signal S3 to correct the addition signal S3. In this case, it is possible to remove the output values V1a and V2a caused by the WS from the addition signal S3 without specifying the position of the WS area.

Furthermore, in the solid-state imaging device 1 according to this embodiment, in the correction process, when at least one of the WS area 11a showing the output value V1b greater than the positive threshold value Tp and the WS area 21a showing the output value V2b less than the negative threshold value Tn is detected in the subtraction signal S4, the signal processing unit 90 can replace the output values V 1 a and V2a of the WS areas 11a and 21a in the addition signal S3 with an output value obtained by doubling the output value of the pixel area, whose output value is between the positive threshold value Tpa and 0, of the first pixel area 11 at the position of the WS areas 11a and 21a in the first signal S1 and the second pixel area 21 at the position of the WS areas 11a and 21a in the second signal S2. Therefore, when the output values V1a and V2a caused by the WS are removed from the addition signal S3, the subtraction and addition of the correction signal S5 are not needed.

Moreover, in the solid-state imaging device 1 according to this embodiment, when at least one of the WS area 11a showing the output value V1b greater than the positive threshold value Tp and the WS area 21a showing the output value V2b less than the negative threshold value Tn is detected in the subtraction signal S4, the signal processing unit 90 can execute the correction process. Therefore, when the WS area is not detected, the execution of the correction process can be omitted.

In addition, the solid-state imaging device 1 according to this embodiment includes the first transfer gate unit 30 for transferring the charge from each of the first pixel areas 11, the second transfer gate unit 40 for transferring the charge from each of the second pixel areas 21, the first horizontal transfer CCD unit 50 for transferring the charge transferred by the first transfer gate unit 30 to the first output unit 70, and the second horizontal transfer CCD unit 60 for transferring the charge transferred by the second transfer gate unit 40 to the second output unit 80. Therefore, it is possible to extend the life of the solid-state imaging device 1 configured to include a CCD.

Further, in the solid-state imaging device 1 according to this embodiment, the first pixel region 10 and the second pixel region 20 are arranged in the first direction D1 such that each of the first pixel areas 11 and each of the second pixel areas 21 are aligned along the first direction D1. Therefore, the same or corresponding light is easily incident on the first pixel region 10 and the second pixel region 20.

Furthermore, in the solid-state imaging device 1 according to this embodiment, the first pixel region 10, the first transfer gate unit 30, and the first horizontal transfer CCD unit 50 are sequentially arranged toward one side of the first direction D1, and the second pixel region 20, the second transfer gate unit 40, and the second horizontal transfer CCD unit 60 are sequentially arranged toward the opposite side of the first direction D1. Therefore, it possible to appropriately dispose the first horizontal transfer CCD unit 50, the second horizontal transfer CCD unit 60, the first transfer gate unit 30, and the second transfer gate unit 40 for the first pixel region 10 and the second pixel region 20 arranged such that the same or corresponding light is easily incident thereon.

In addition, the solid-state imaging device 1 according to this embodiment includes the first output unit 70 that receives the charge generated in the first light receiving unit 5 and outputs the first signal S1 and the second output unit 80 that receives the charge generated in the second light receiving unit 6 and outputs the second signal S2. As described above, since the output units corresponding to the first light receiving unit 5 and the second light receiving unit 6 are provided, it is possible to improve a processing speed.

Moreover, in the solid-state imaging device 1 according to this embodiment, the first pixel area 11 includes a plurality of first pixels 12 arranged along the first direction D1, and the second pixel area 21 includes a plurality of second pixels 22 arranged along the first direction D1. Therefore, binning can be performed, and a signal-to-noise ratio of the output signal So is high.

Further, in the solid-state imaging device 1 according to this embodiment, the first pixel region 10 and the second pixel region 20 are disposed adjacent to each other the element isolation portion may be interposed therebetween). Therefore, since the first pixel region 10 and the second pixel region 20 are disposed close to each other, the characteristics of the regions are close to each other, which makes it possible to perform more appropriate correction.

Furthermore, the signal processing method according to this embodiment also contributes to extending the life of the solid-state imaging device 1 for the same reasons as described above.

The above embodiment describes an aspect of the present invention. Therefore, the present invention is not limited to the above-described embodiment, and the aspect described in the above embodiment can be modified in any manner. Next, modification examples will be described.

### [First Modification Example]

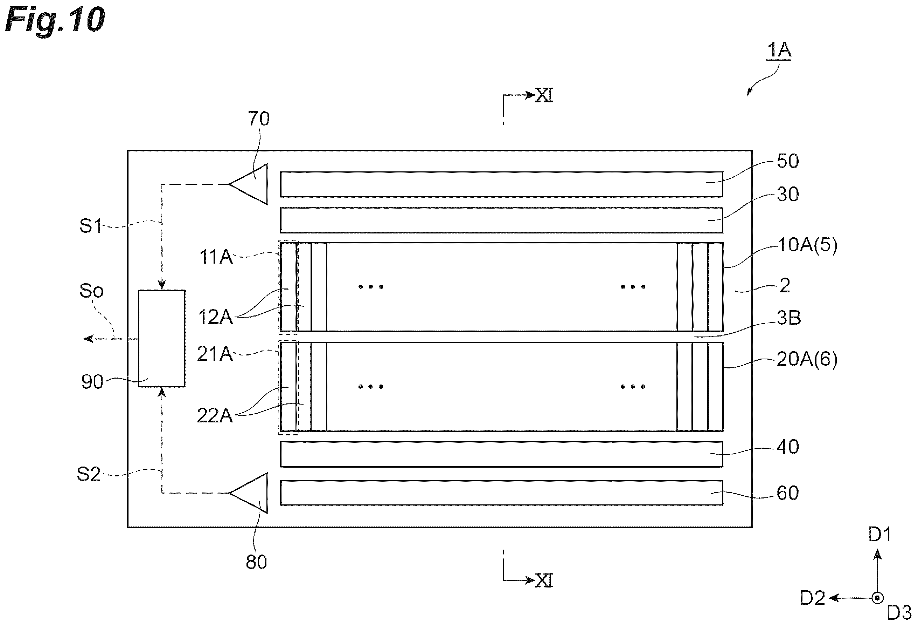

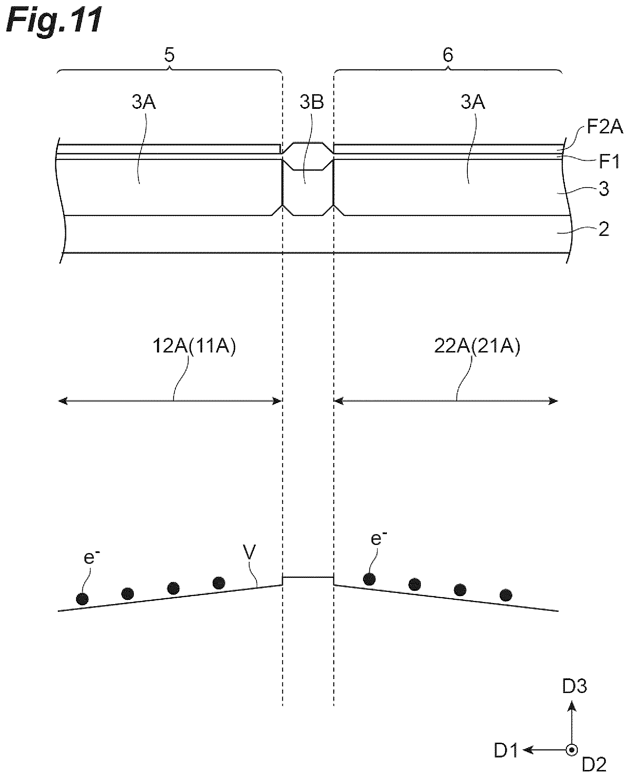

FIG. 10 is a schematic plan view showing a first modification example of the solid-state imaging device. FIG. 11 is a schematic partial cross-sectional view taken along a line XI-XI of FIG. 10 and is a schematic view showing a potential in the cross section. A cross-sectional view (without hatching) taken along the line XI-XI is shown in an upper portion of FIG. 11, and a potential V in the cross section is shown in a lower portion of FIG. 11.

A solid-state imaging device 1A shown in FIGS. 10 and 11 differs from the solid-state imaging device 1 according to the embodiment in that the solid-state imaging device 1A is a resistive-gate CCD while the solid-state imaging device 1 according to the embodiment is a binning CCD. Specifically, the solid-state imaging device 1A differs from the solid-state imaging device 1 in that it includes a first pixel region 10A instead of the first pixel region 10 and includes a second pixel region 20A instead of the second pixel region 20.

The first pixel region 10A has a plurality of first pixel areas 11A arranged along the second direction D2. Each of the first pixel areas 11A includes one first pixel 12A extending along the first direction D1. The first pixel 12A generates charge in response to incidence of light. Therefore, the first pixel region 10A constitutes a first light receiving unit 5 generating charge in response to incidence of light.

The second pixel region 20A has a plurality of second pixel areas 21A arranged along the second direction D2. Each of the second pixel areas 21A includes one second pixel 22A extending along the first direction D1. The second pixel 22A generates charge in response to incidence of light. Therefore, the second pixel region 20A constitutes a second light receiving unit 6 generating charge in response to incidence of light.

Here, the first pixel region 10A and the second pixel region 20A are disposed such that end portions thereof in the second direction D2 are matched with each other. Therefore, each of the plurality of first pixel areas 11A and each of the plurality of second pixel areas 21A (which are the same in number as the first pixel areas 11A) are aligned in the first direction D1.

A cross-sectional structure of the solid-state imaging device 1A includes a semiconductor substrate 2 and a semiconductor layer 3 similarly to the solid-state imaging device 1, and a high-resistance electrode F2A constituting a resistive-gate structure is provided on an insulating film F1. The high-resistance electrode F2A is provided on each of a pair of first regions 3A of the semiconductor layer 3 and defines the individual first pixel 12A (first pixel area 11A) and the individual second pixel 22A (second pixel area 21A). In the solid-state imaging device 1A, different voltages are applied to both ends of the high-resistance electrode F2A to form a potential slope and to transfer charge e. This makes it possible to achieve high-speed transfer and to perform reading with a small amount of residual charge even when a pixel height is large.

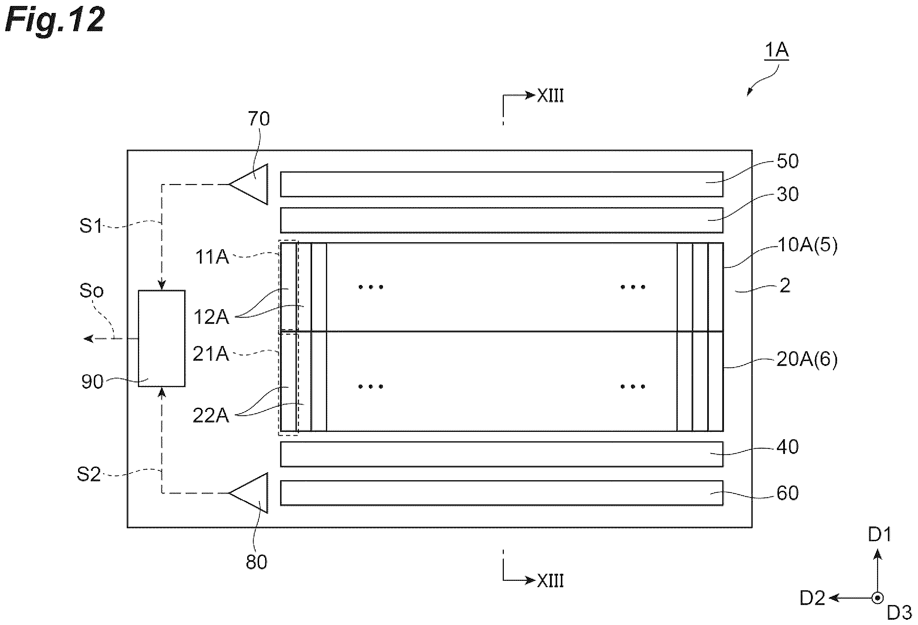

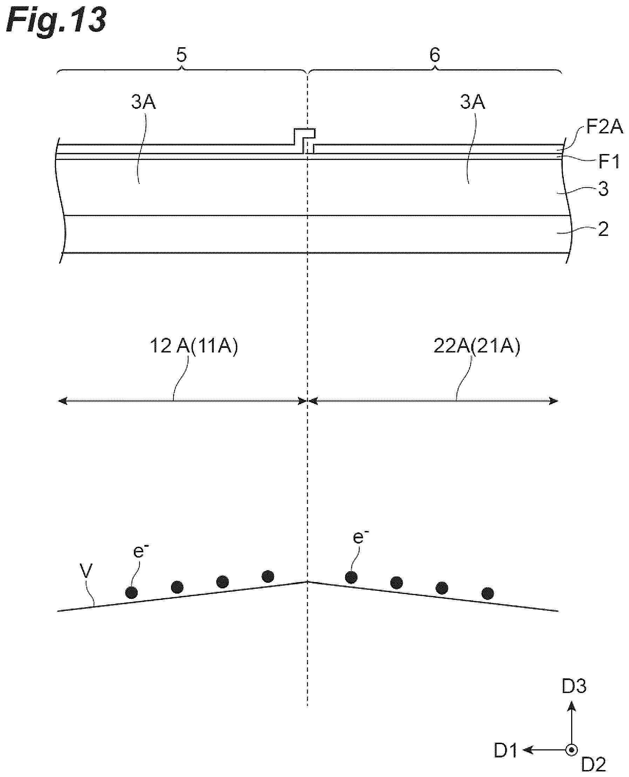

Further, in the example shown in FIGS. 10 and 11, an element isolation portion by a second region 3B is interposed between the first light receiving unit 5 (first pixel region 10A) and the second light receiving unit 6 (second pixel region 20A). However, as shown in FIGS. 12 and 13, the second region 3B of the first conductivity type may not be provided in the semiconductor layer 3 such that the first light receiving unit 5 (first pixel region 10A) and the second light receiving unit 6 (second pixel region 20A) are disposed adjacent to each other in the first direction D1 without the element isolation portion interposed therebetween.

Furthermore, FIG. 12 is a schematic plan view showing another example of the solid-state imaging device according to the modification example. FIG. 13 is a schematic partial cross-sectional view taken along a line XIII-XIII of FIG. 12 and is a schematic view showing a potential in the cross section. A cross-sectional view (without hatching) taken along the line XIII-XIII is shown in an upper portion of FIG. 13, and a potential V in the cross section is shown in a lower portion of FIG. 13.

### [Second Modification Example]

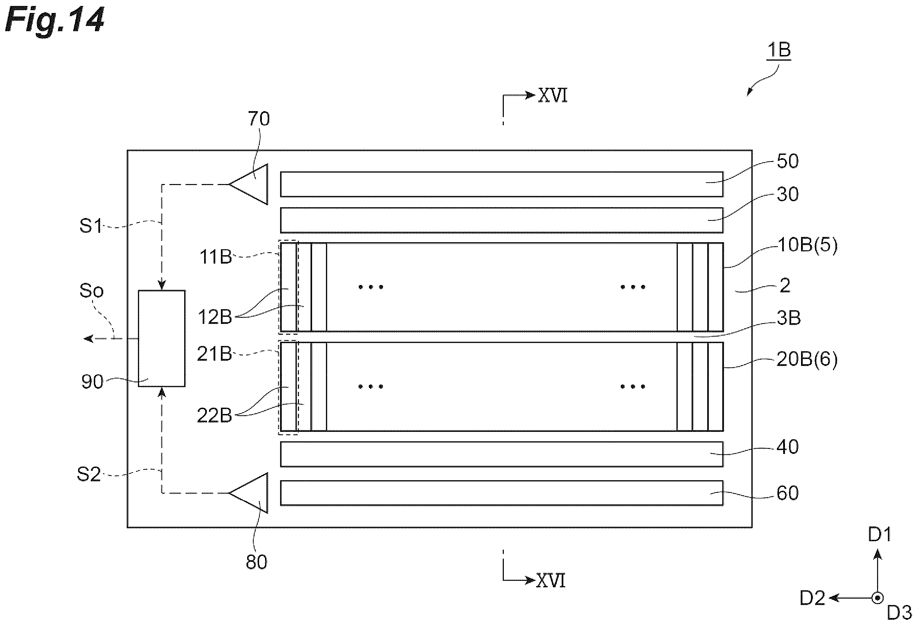

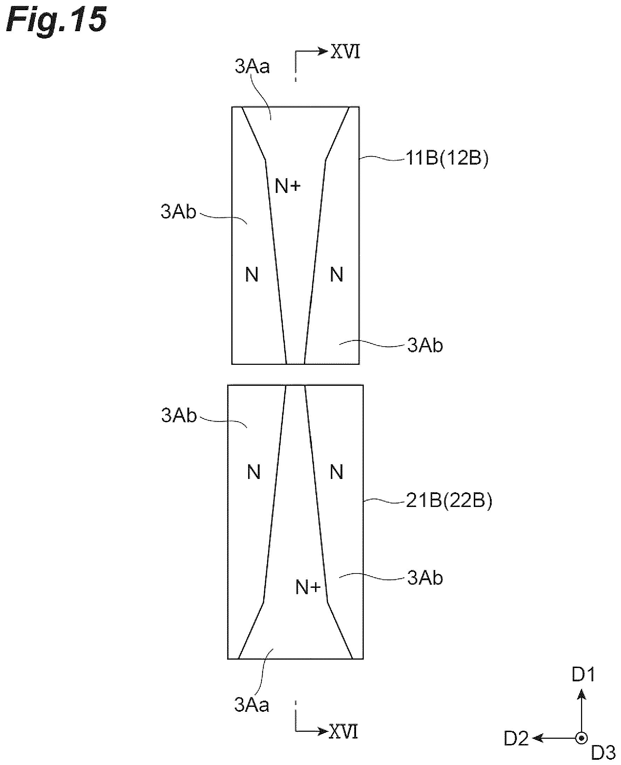

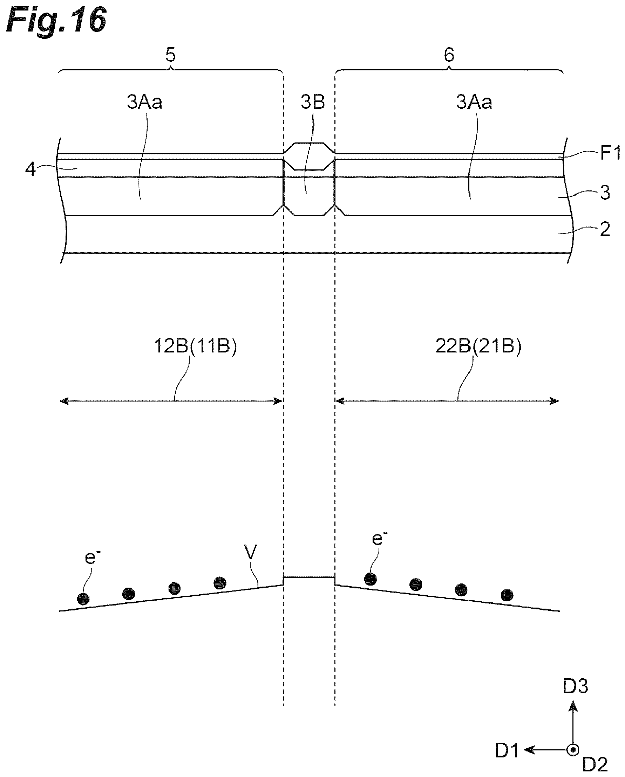

FIG. 14 is a schematic plan view showing a second modification example of the solid-state imaging device, and FIG. 15 is an enlarged schematic plan view showing a portion of FIG. 14. FIG. 16 is a schematic partial cross-sectional view taken along a line XVI-XVI of FIGS. 14 and 15 and is a schematic view showing a potential in the cross section. A cross-sectional view (without hatching) taken along the line XVI-XVI is shown in an upper portion of FIG. 16, and a potential V in the cross section is shown in a lower portion of FIG. 16.

A solid-state imaging device 1B shown in FIGS. 14 to 16 differs from the solid-state imaging device 1 according to the embodiment in that it is a CCD of a buried PD (photodiode) type while the solid-state imaging device 1 according to the embodiment is the binning CCD. Specifically, the solid-state imaging device 1B differs from the solid-state imaging device 1 in that it includes a first pixel region 10B instead of the first pixel region 10 and includes a second pixel region 20B instead of the second pixel region 20.

The first pixel region 10B has a plurality of first pixel areas 11B arranged along the second direction D2. Each of the first pixel areas 11B includes one first pixel 12B extending along the first direction D1. The first pixel 12B generates charge in response to incidence of light. Therefore, the first pixel region 10B constitutes a first light receiving unit 5 generating charge in response to incidence of light.

The second pixel region 20B has a plurality of second pixel areas 21B arranged along the second direction D2. Each of the second pixel areas 21B includes one second pixel 22B extending along the first direction D1. The second pixel 22B generates charge in response to incidence of light. Therefore, the second pixel region 20B constitutes a second light receiving unit 6 generating charge in response to incidence of light.

Here, the first pixel region 10B and the second pixel region 20B are disposed such that end portions thereof in the second direction D2 are matched with each other. Therefore, each of the plurality of first pixel areas 11B and each of the plurality of second pixel areas 21B (which are the same in number as the first pixel areas 11B) are aligned in the first direction D1.

A cross-sectional structure of the solid-state imaging device 1B has a semiconductor substrate 2 and a semiconductor layer 3 similarly to the solid-state imaging device 1, and a semiconductor layer 4 of the first conductivity type (here, a P⁺ type) is provided between the semiconductor layer 3 and an insulating film F1. Therefore, a P⁺N⁺P structure in which a P⁺ diffusion layer (semiconductor layer 4) is provided on the surface side of the first light receiving unit 5 and the second light receiving unit 6 is formed.

In addition, the semiconductor layer 3 includes a channel portion 3Ab of a second conductivity type (here, an N type) and a channel additional injection portion 3Aa of the second conductivity type (here, an N⁺ type) having a higher impurity concentration than the channel portion 3Ab in a region corresponding to the first region 3A of the semiconductor layer 3 of the solid-state imaging device 1. The channel additional injection portion 3Aa is formed such that the width thereof increases toward each of the first transfer gate unit 30 and the second transfer gate unit 40. Therefore, a potential slope is formed to transfer the charge e. According to this structure, the transfer electrode is not formed, and high quantum efficiency is achieved even in a front-illuminated type.

### [Other Modification Examples]

The solid-state imaging device 1 (and the solid-state imaging devices 1A and 1B (the same applies hereinafter)) is configured as a CCD image sensor including a transfer gate and a horizontal transfer gate CCD unit, but may be configured as a CMOS image sensor instead of the CCD image sensor.

In addition, the solid-state imaging device 1 has the form in which the first pixel region 10 and the second pixel region 20 are disposed such that the end portions thereof in the second direction D2 are matched with each other and each of the plurality of first pixel areas 11 and each of the plurality of second pixel areas 21 (which are the same in number as the first pixel areas 11) are aligned in the first direction D1. However, when the first pixel region 10 and the second pixel region 20 are disposed along the first direction D1 such that the end portions of the first pixel region 10 and the second pixel region 20 in the second direction D2 are matched with each other, the first pixel areas 11 and the second pixel areas 21 should at least be associated with each other such that each of the plurality of first pixel areas 11 and each of the plurality of second pixel areas 21 are aligned along the first direction D1.

That is, the first pixel region 10 and the second pixel region 20 may be arranged along the first direction D1 while the end portions thereof in the second direction D2 deviate from each other (are shifted in the second direction D2). In this case, some first pixel areas 11 of the first pixel region 10 and some second pixel areas 21 of the second pixel region 20 are arranged so as to overlap each other in the first direction. Alternatively, the first pixel region 10 and the second pixel region 20 may not have an overlapping portion therebetween in the first direction D1 and may be arranged along the second direction D2.

Further, the positional relationships between the first pixel region 10 and the second pixel region 20, between the first transfer gate unit 30 and the second transfer gate unit 40, and between the first horizontal transfer CCD unit 50 and the second horizontal transfer CCD unit 60 are not limited to the above-described form and can be modified in any manner. For example, the components may be arranged from one side to the other side in the first direction D1 in the order of the second pixel region 20, the second transfer gate unit 40, the second horizontal transfer CCD unit 60, the first pixel region 10, the first transfer gate unit 30, and the first horizontal transfer CCD unit 50.

Furthermore, the solid-state imaging device 1 includes the first output unit 70 and the second output unit 80 as the output units, but may include only one output unit. Moreover, a gap other than the element isolation portion may be formed between the first pixel region 10 and the second pixel region 20 such that the first pixel region 10 and the second pixel region 20 are separated from each other.

In addition, in the solid-state imaging device 1, there are two pixel regions of the first pixel region 10 and the second pixel region 20, but the number of pixel regions is not limited to two and may be any number n. When three or more pixel regions are provided, it is possible to more reliably perform correction for removing the output values caused by the WS, as compared to when two pixel regions are provided. That is, in a case where three or more pixel regions are provided, even when the WS occurs in pixel areas at the same position corresponding to each other in two of the pixel regions, it is possible to perform the same correction as described above using a signal from the remaining pixel region.

When the number of pixel regions is n that is equal to or greater than 2, first, two pixel regions are selected from the n pixel regions, and the generation of the correction signal S5 or the extraction of the position of the WS area is performed in the same manner as described above. Then, these processes are performed on all combinations of the pixel regions. Then, the correction signals S5 or positional information items of the WS areas obtained from all of the combinations are combined to complete the correction signal S5 or the positional information. Then, the subtraction of the obtained correction signal S5 or the replacement of an output value corresponding to the positional information is performed on the addition signal S3 of the signals from all of the pixel regions to generate the output signal So.

Furthermore, the present disclosure is not limited to the case where light is equally incident on the first pixel region 10 and the second pixel region 20, and light components having a known correspondence relationship may be incident on the pixel regions, respectively. For example, the light components having a known correspondence relationship are in a state in which, when one light component is branched and incident on the first pixel region 10 and the second pixel region 20, the ratio of light intensities in the first pixel region 10 and the second pixel region 20 is known.

### Industrial Applicability

According to the present disclosure, a solid-state imaging device and a signal processing method that can achieve a longer life are provided.

### Reference Signs List

1, 1A, 1B: solid-state imaging device, 5: first light receiving unit, 6: second light receiving unit, 10, 10A, 10B: first pixel region, 11, 11A, 11B: first pixel area, 12, 12A, 12B: first pixel, 20, 20A, 20B: second pixel region, 21, 21A, 21B: second pixel area, 22, 22A, 22B: second pixel, 30: first transfer gate unit, 40: second transfer gate unit, 50: first horizontal transfer CCD unit, 60: second horizontal transfer CCD unit, 70: first output unit (output unit), 80: second output unit, 90: signal processing unit, S1: first signal, S2: second signal, S3: addition signal, S4: subtraction signal, S5: correction signal, So: output signal.

## Claims

1. A solid-state imaging device comprising:
first and second light receiving units configured to generate charge in response to incidence of light;
an output unit configured to output a first signal corresponding to the charge generated in the first light receiving unit and configured to output a second signal corresponding to the charge generated in the second light receiving unit; and
a signal processing unit configured to process the signals output from the output unit,
wherein the first light receiving unit has a first pixel region configured by arranging a plurality of first pixel areas, each of which includes a plurality of first pixels arranged along a first direction or one first pixel, along a second direction intersecting the first direction,
the second light receiving unit has a second pixel region configured by arranging a plurality of second pixel areas, each of which includes a plurality of second pixels arranged along the first direction or one second pixel, along the second direction,
when the first pixel region and the second pixel region are disposed along the first direction such that end portions of the first pixel region and the second pixel region in the second direction are matched with each other, the first pixel areas and the second pixel areas are associated with each other such that each of the plurality of first pixel areas and each of the plurality of second pixel areas are aligned along the first direction, and
signal processing of the signal processing unit includes:
an addition signal generation process of adding the first signal and the second signal to generate an addition signal;
a subtraction signal generation process of subtracting the second signal from the first signal to generate a subtraction signal; and
a correction process of correcting the addition signal on the basis of the subtraction signal then outputting the addition signal.

2. The solid-state imaging device according to claim 1,
wherein, in the correction process, the signal processing unit generates a correction signal on the basis of the subtraction signal and subtracts the correction signal from the addition signal to correct the addition signal, and
when a white spot area, which is the pixel area showing an output value less than a negative threshold value, is recognized in the correction signal, a sign of the output value of the white spot area is changed to a positive sign.

3. The solid-state imaging device according to claim 2,
wherein, in the correction process, the signal processing unit generates the correction signal in all of the first pixel areas and all of the second pixel areas and subtracts the correction signal from the addition signal to correct the addition signal.

4. The solid-state imaging device according to claim 1,
wherein, in the correction process, the signal processing unit generates a correction signal on the basis of the subtraction signal and adds the correction signal to the addition signal to correct the addition signal, and
when a white spot area, which is the pixel area showing an output value greater than a positive threshold value, is recognized in the correction signal, a sign of the output value of the white spot area is changed to a negative sign.

5. The solid-state imaging device according to claim 4,
wherein, in the correction process, the signal processing unit generates the correction signal in all of the first pixel areas and all of the second pixel areas and adds the correction signal to the addition signal to correct the addition signal.

6. The solid-state imaging device according to any one of claims 2 to 5,
wherein, in the correction process, the signal processing unit sets an output value of the pixel area showing the output value between a positive threshold value and a negative threshold value in the correction signal to 0.

7. The solid-state imaging device according to claim 1,
wherein, in the correction process, when a white spot area, which is the pixel area showing an output value greater than a positive threshold value, is detected in the subtraction signal, the signal processing unit replaces the output value of the white spot area in the addition signal with an output value obtained by doubling an output value of the second pixel area at a position in the second signal corresponding to a position of the white spot area, and
when a white spot area, which is the pixel area showing an output value less than a negative threshold value, is detected in the subtraction signal, the signal processing unit replaces the output value of the white spot area in the addition signal with an output value obtained by doubling an output value of the first pixel area at a position in the first signal corresponding to a position of the white spot area.

8. The solid-state imaging device according to any one of claims 1 to 7,
wherein, when at least one of a white spot area, which is the pixel area showing an output value greater than a positive threshold value, and a white spot area, which is the pixel area showing an output value less than a negative threshold value, is detected in the subtraction signal, the signal processing unit executes the correction process.

9. The solid-state imaging device according to any one of claims 1 to 8, further comprising:
a first transfer gate unit configured to transfer the charge from each of the first pixel areas;
a second transfer gate unit configured to transfer the charge from each of the second pixel areas;
a first horizontal transfer CCD unit configured to transfer the charge transferred by the first transfer gate unit to the output unit; and
a second horizontal transfer CCD unit configured to transfer the charge transferred by the second transfer gate unit to the output unit.

10. The solid-state imaging device according to claim 9,
wherein the first pixel region and the second pixel region are arranged in the first direction such that each of the first pixel areas and each of the second pixel areas are aligned along the first direction.

11. The solid-state imaging device according to claim 10,
wherein the first pixel region, the first transfer gate unit, and the first horizontal transfer CCD unit are sequentially arranged toward one side of the first direction, and
the second pixel region, the second transfer gate unit, and the second horizontal transfer CCD unit are sequentially arranged toward an opposite side of the first direction.

12. The solid-state imaging device according to any one of claims 1 to 11,
wherein the output unit includes:
a first output unit configured to receive the charge generated in the first light receiving unit and configured to output the first signal; and
a second output unit configured to receive the charge generated in the second light receiving unit and configured to output the second signal.

13. The solid-state imaging device according to any one of claims 1 to 12,
wherein the first pixel area includes a plurality of first pixels arranged along the first direction, and
the second pixel area includes a plurality of second pixels arranged along the first direction.

14. The solid-state imaging device according to any one of claims 1 to 13,
wherein the first pixel region and the second pixel region are disposed adjacent to each other.

15. A signal processing method for a solid-state imaging device including first and second light receiving units configured to generate charge in response to incidence of light and an output unit configured to output a first signal corresponding to the charge generated in the first light receiving unit and configured to output a second signal corresponding to the charge generated in the second light receiving unit, the signal processing method comprising:
an addition signal generation step of adding the first signal and the second signal to generate an addition signal;
a subtraction signal generation step of subtracting the second signal from the first signal to generate a subtraction signal; and
a correction step of correcting the addition signal on the basis of the subtraction signal then outputting the addition signal,
wherein the first light receiving unit has a first pixel region configured by arranging a plurality of first pixel areas, each of which includes a plurality of first pixels arranged along a first direction or one first pixel, along a second direction intersecting the first direction,
the second light receiving unit has a second pixel region configured by arranging a plurality of second pixel areas, each of which includes a plurality of second pixels arranged along the first direction or one second pixel, along the second direction, and
when the first pixel region and the second pixel region are disposed along the first direction such that end portions of the first pixel region and the second pixel region in the second direction are matched with each other, the first pixel areas and the second pixel areas are associated with each other such that each of the plurality of first pixel areas and each of the plurality of second pixel areas are aligned along the first direction.
